# EUROPEAN PATENT APPLICATION

(11) **EP 4 447 630 A1**
(43) Date of publication of application: **16.10.2024**
(21) Application number: 24163400.5
(22) Date of filing: 13.03.2024
(51) Int. Cl.: H05K 7/20

(54) **POWER-SUPPLY-UNIT ASSEMBLY STRUCTURE**

(30) Priority: 12.04.2023 IN 202321027056
(71) Applicant: Delta Electronics, Inc., Taoyuan City 33370 (TW)
(72) Inventor: Li, Yi-Syuan, 32063 Taoyuan City (TW); Ajitha,, 32063 Taoyuan City (TW); Hsu, Ching-Chuan, 32063 Taoyuan City (TW)
(74) Representative: Uexküll & Stolberg

(57) **Abstract**

A power-supply-unit assembly structure (1) is disclosed and includes a housing base (10), a cover (30) and a PSU. The housing base (10) includes two opposite ending walls (11, 12) and two lateral walls (13a, 13b) disposed around a bottom plate (14) to form an accommodation for accommodating a main body (40) of the PSU, and coved by the cover (30). A ventilation inlet (21) and a ventilation outlet (22) passing through the two lateral walls (13a, 13b) are disposed adjacent to the two opposite ending walls (11, 12), respectively, and in communication with each other through circuitous paths formed through retaining walls (15, 16). The PSU includes a fan (42) configured to drive an airflow transported along the circuitous paths, so that the heat dissipation performance is enhanced, a water-repellent structure is provided, and the protection and the portability are improved.

## Description

### FIELD OF THE INVENTION

The present disclosure relates to an electronic assembly structure, and more particularly to a power-supply-unit assembly structure for improving the protection level of the power supply unit, ensuring the heat dissipation performance and increasing the portability of the power supply unit at the same time.

### BACKGROUND OF THE INVENTION

A power supply unit (PSU) is a type of power converter. Usually, a conventional PSU includes a simple case for accommodating the internal electronic components thereof. Furthermore, some of the internal electronic components generate a lot of heat during operation, and it is necessary to combine the hosing with a fan for heat dissipation. However, considering the design of the airflow required by the fan, the traditional PSU assembly structure can only achieve IP20 protection. On the other hand, with the arrangement of the fan, the conventional PSU assembly structure is not easy to be applied in a relatively harsh semi-outdoor or outdoor environment, so that the use environment of the PSU is limited, and the portability of PSU is not good.

Therefore, there is a need of providing a power-supply-unit assembly structure to improve the protection level of the power supply unit, ensure the heat dissipation performance, increase the portability of the power supply unit, and obviate the drawbacks encountered by the prior arts.

### SUMMARY OF THE INVENTION

An object of the present disclosure is to provide a power-supply-unit assembly structure to improve the protection level of the power supply unit for dustproof, waterproof and impact resistance, and be capable of ensuring the heat dissipation performance.

Another object of the present disclosure is to provide a power-supply-unit assembly structure. Under improving the protection level of the power supply unit for dustproof, waterproof and impact resistance and enhancing heat dissipation performance, it facilitates to install or achieve the portability at the same time.

A further object of the present disclosure is to provide a power-supply-unit assembly structure. With the main body of the power supply unit fixed through the combination of the housing base and the cover, it facilitates to improve the protection strength of the original power supply unit and make the entire assembly structure to meet the characteristic requirements of portable supply devices. Preferably, the airflow path formed by the combination of the housing base and the cover body is designed in a circuitous path. The ventilation inlet and the ventilation outlet are equipped with the protective retaining wall structures correspondingly, so that a waterproof structure is formed between the outer lateral wall and the internal retaining wall. In addition, the housing base includes a built-in replaceable dust-proof filter screen to achieve a comprehensive improvement of the protection level. In that, the power-supply-unit assembly structure is suitable for semi-outdoor and outdoor environments. The accommodation space is formed by the combination of the housing base and the cover, it allows to change the capacity of the built-in power supply unit according to different power demands. On the other hand, the housing base and the cover are connected to each other closely through the sealing rubber ring. Preferably, the sealing rubber ring is a waterproof rubber ring embedded on the abutting surface of the cover by means of injection molding. It is conducive to repeated disassembly and replacement of the filter screen disposed on the housing base. Furthermore, it facilitates to prevent the sealing rubber ring from displacement failure after the user detaches the cover. When the housing base and the cover are assembled with each other and connected closely, the sealing protection between the housing base and the cover is achieved through the sealing rubber ring. It allows to replace the filter screens at different dust-proof grades according to the use requirements, so as to optimize the dust-proof effects of the power supply unit. Furthermore, the power-supply-unit assembly structure includes a hanging hole for hanging it on a wall. Preferably, the hanging hole is equipped with a special waterproof-dustproof cap for achieving sealing and protection, and the airflow driven by the fan of the power supply unit is not affected. In other words, when the housing base and the cover are assembled with each other and connected closely, the circuitous structures are formed between the outer lateral wall and the inner retaining wall to avoid the water intrusion. In that, the dry air inhaled from the ventilation inlet is transported in a circuitous path and filtered through the filter, flows into the power supply unit for cooling cool the internal electronic components. Finally, the heat-exchanged air is discharged out of the ventilation outlet. In this way, a smooth airflow is maintained in the power-supply-unit assembly structure of the present disclosure. Moreover, the heat dissipation performance is enhanced, a water-repellent structure is provided, and the protection and the portability are improved at the same time.

In accordance with an aspect of the present disclosure, a power-supply-unit assembly structure is provided and includes a housing base, a cover and a power supply unit. The housing base includes a first ending wall, a second ending wall, two lateral walls and a bottom plate. The first ending wall and the second ending wall opposite to each other, and the two lateral walls connected between the first ending wall and the second ending wall, respectively, are disposed around the bottom plate to form an accommodation space. The housing base further includes a ventilation inlet, a ventilation outlet, a first retaining wall, a second retaining wall and a wire-in through hole. The ventilation inlet runs through the lateral wall and is disposed adjacent to the first ending wall. The ventilation outlet runs through the lateral wall and is disposed adjacent to the second ending wall, the first retaining wall is spatially corresponding to the ventilation inlet and arranged between the ventilation inlet and the accommodation space, the second retaining wall is spatially corresponding to the ventilation outlet and arranged between the ventilation outlet and the accommodation space, the ventilation inlet is in communication with the ventilation outlet through the accommodation space, and the wire-inlet through hole is disposed on the second ending wall. The cover is spatially corresponding to the housing base and detachably connected to the first ending wall, the second ending wall, the two lateral walls, the first retaining wall and the second retaining wall of the housing base. The power supply unit includes a main body and a power cord. The main body is accommodated in the accommodation space and includes a fan, the fan is configured to drive an airflow, which is inhaled through the ventilation inlet, transported along the first retaining wall into the accommodation space, flowing through the main body of the power supply unit in the accommodation space, then transported along the second retaining wall and discharged through the ventilation outlet, and the power cord passes through the wire-in through hole on the second ending wall and is connected to the main body.

In an embodiment, the housing base includes a first fastened hole, the cover includes a second fastened hole, and the first fastened hole and the second fastened hole are engaged with each other through a fastening element, wherein a top edge collaboratively formed by the first ending wall, the second ending wall, the two lateral walls, the first retaining wall and the second retaining wall abuts against a joint surface of the cover, and the housing base and the cover are closely connected to each other.

In an embodiment, the cover includes a sealing rubber ring embedded in the joint surface of the cover through an accommodation groove on the joint surface, and spatially corresponding to the top edge collaboratively formed by the first ending wall, the second ending wall, the two lateral walls, the first retaining wall and the second retaining wall.

In an embodiment, the two lateral walls are arranged in pairs and includes two first adjoining sections connected to two opposite ends of the first ending wall, respectively, and the two first adjoining sections have a spaced distance reduced gradually in a first direction approaching toward the first ending wall, wherein two of the ventilation inlets are arranged in pairs on the two first adjoining sections and passing through the two first adjoining sections, respectively.

In an embodiment, two of the first retaining walls are arranged in pairs and connected to ends of the two first adjoining sections away from the first ending wall, wherein the two first retaining walls have a spaced distance reduced gradually in the first direction approaching toward the first ending wall.

In an embodiment, a first buffer chamber is formed between each one of the first adjoining sections and a corresponding one of the two first retaining walls, a first communication chamber is formed between the two first retaining walls, and the airflow is inhaled into the first buffer chamber through the ventilation inlet, transported through the first communication chamber, and then introduced toward the main body of the power supply unit in the accommodation space.

In an embodiment, the power-supply-unit assembly structure further includes a dustproof filter screen arranged between the two first retaining walls, and located between the first ending wall and the main body of the power supply unit.

In an embodiment, the housing base further includes a filter-screen sliding slot arranged among the bottom plate and the two first retaining walls, and the dustproof filter screen is detachably accommodated in the filter-screen sliding slot, and fixed among the joint surface of the cover and the bottom plate and the two first retaining walls.

In an embodiment, the two lateral walls are arranged in pairs and includes two second adjoining sections connected to two opposite ends of the second ending wall, respectively, and the two first adjoining sections have a spaced distance reduced gradually in a second direction approaching toward the second ending wall, wherein two of the ventilation outlets are arranged in pairs on the two second adjoining sections and passing through the two second adjoining sections, respectively.

In an embodiment, two of the second retaining walls are arranged in pairs and connected to ends of the two second adjoining sections away from the second ending wall, wherein the two second retaining walls have a spaced distance reduced gradually in the second direction approaching toward the second ending wall.

In an embodiment, a second buffer chamber is formed between each one of the second adjoining sections and a corresponding one of the two second retaining walls, a second communication chamber is formed between the two second retaining walls, and the airflow is transported into the second communication chamber from the main body of the power supply unit in the accommodation space, and then discharged out of the ventilation outlet through the second buffer chamber.

In an embodiment, the housing base further includes at least one hanging hole embedded from an outer side of the bottom plate and disposed adjacent to the first ending wall or/and the second ending wall.

In an embodiment, the hanging hole runs through the bottom plate, and the housing base further includes a cap covering the hanging hole from an inner side of the bottom plate to the outer side, so that the hanging hole and the accommodation space isolated.

In an embodiment, the housing base further includes a handle disposed on an outside of one of the two lateral walls.

In an embodiment, the two lateral walls are arranged in pairs and includes two first adjoining sections, two second adjoining sections and two recessed sections, the two first adjoining sections are connected to two opposite ends of the first ending wall, respectively, and have a spaced distance reduced gradually in a first direction approaching toward the first ending wall, the two second adjoining sections are connected to two opposite ends of the second ending wall, respectively, and have a spaced distance reduced gradually in a second direction approaching toward the second wall, and the two recessed sections are connected between the two first adjoining sections and the two second adjoining sections and arranged in parallel to each other.

In an embodiment, the housing base further includes a handle disposed on an outside of one of the two recessed sections.

In an embodiment, the power-supply-unit assembly structure further includes a buffer spacer disposed between the main body of the power supply unit and the two lateral walls of the housing base.

In an embodiment, the power-supply-unit assembly structure further includes a buffer spacer disposed between the main body of the power supply unit and the bottom plate of the housing base.

In an embodiment, the power-supply-unit assembly structure further includes a buffer spacer disposed between the main body of the power supply unit and the joint surface of the cover.

In an embodiment, the ventilation inlet and the ventilation outlet are in a multi-hole structure.

### BRIEF DESCRIPTION OF THE DRAWINGS

The above contents of the present disclosure will become more readily apparent to those ordinarily skilled in the art after reviewing the following detailed description and accompanying drawings, in which:
FIG. 1 is an exploded view illustrating a power-supply-unit assembly structure according to an embodiment of the present disclosure;
FIG. 2 is an exploded view illustrating the power-supply-unit assembly structure according to the embodiment of the present disclosure and taken from another perspective;
FIG. 3 is a perspective structural view illustrating the power-supply-unit assembly structure according to the embodiment of the present disclosure;
FIG. 4 is a schematic diagram showing the assembly of the cover and the housing base of the power-supply-unit assembly structure according to the embodiment of the present disclosure;
FIG. 5 is a schematic diagram showing the assembly of the cover and the housing base of the power-supply-unit assembly structure according to the embodiment of the present disclosure and taken from another perspective;
FIG. 6 is a schematic diagram showing the assembly and disassembly of the dustproof filter screen in the power-supply-unit assembly structure according to the embodiment of the present disclosure;
FIG. 7 is a schematic diagram showing the path of airflow in the power-supply-unit assembly structure according to the embodiment of the present disclosure; and
FIG. 8 is a schematic diagram showing the power-supply-unit assembly structure hung in use according to the embodiment of the present disclosure.

### DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed. For example, the formation of a first feature over or on a second feature in the description that follows may include embodiments in which the first and second features are formed in direct contact, and may also include embodiments in which additional features may be formed between the first and second features, such that the first and second features may not be in direct contact. In addition, the present disclosure may repeat reference numerals and/or letters in the various examples. This repetition is for the purpose of simplicity and clarity and does not in itself dictate a relationship between the various embodiments and/or configurations discussed. Further, spatially relative terms, such as "top," "bottom," "front," "rear" and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly. When an element is referred to as being "connected," or "coupled," to another element, it can be directly connected or coupled to the other element or intervening elements may be present. Although the wide numerical ranges and parameters of the present disclosure are approximations, numerical values are set forth in the specific examples as precisely as possible. In addition, although the "first," "second," "third," and the like terms in the claims be used to describe the various elements can be appreciated, these elements should not be limited by these terms, and these elements are described in the respective embodiments are used to express the different reference numerals, these terms are only used to distinguish one element from another element. For example, a first element could be termed a second element, and, similarly, a second element could be termed a first element, without departing from the scope of example embodiments.

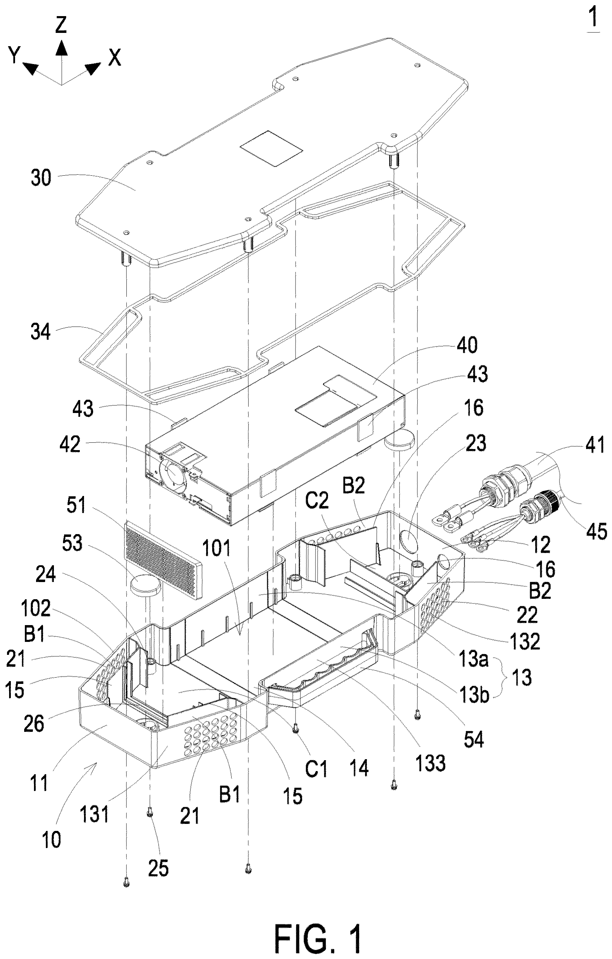

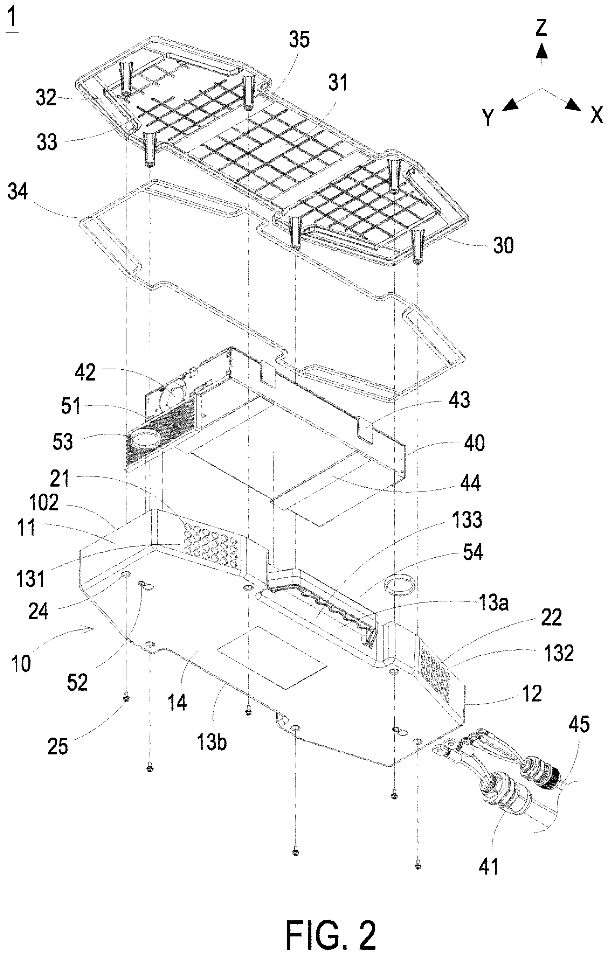

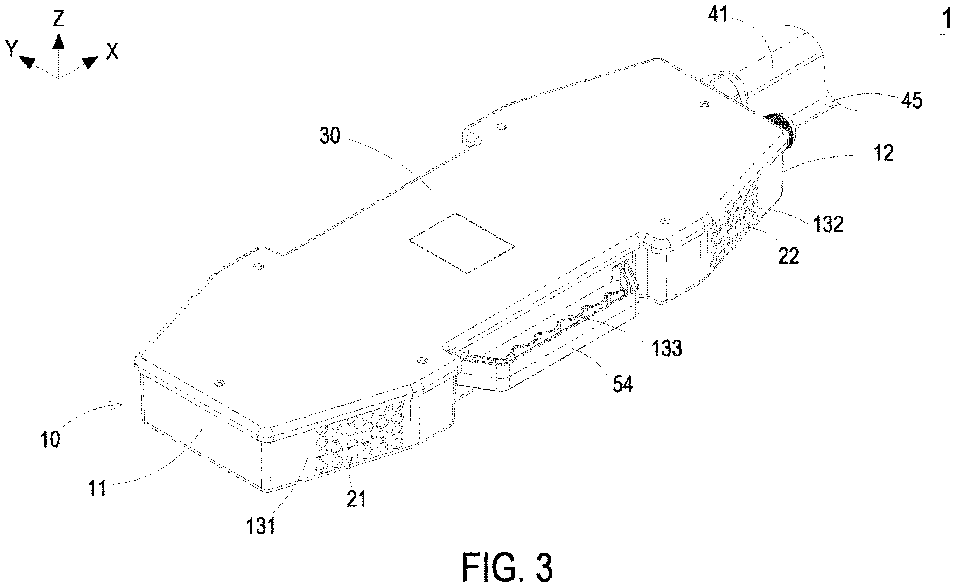

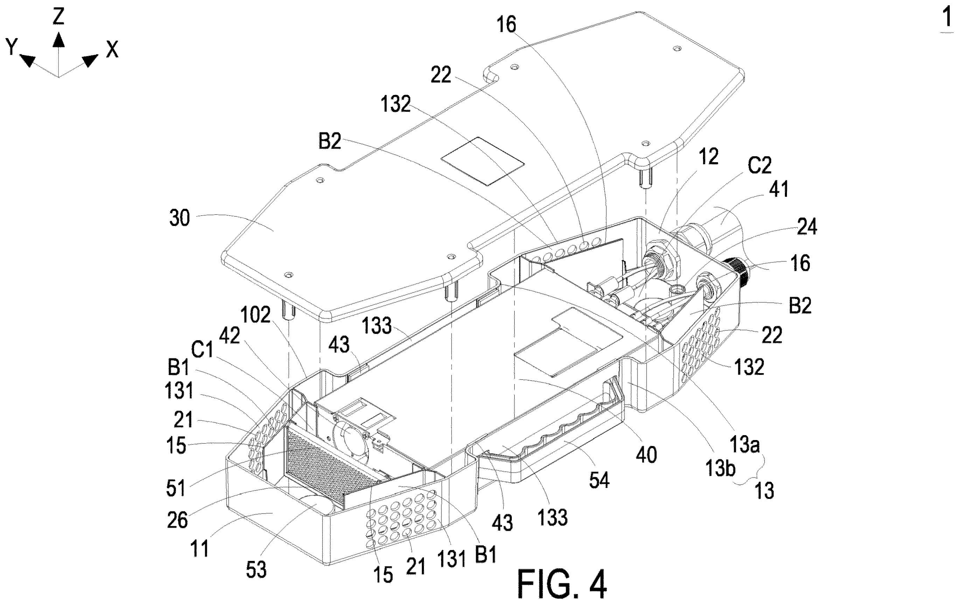

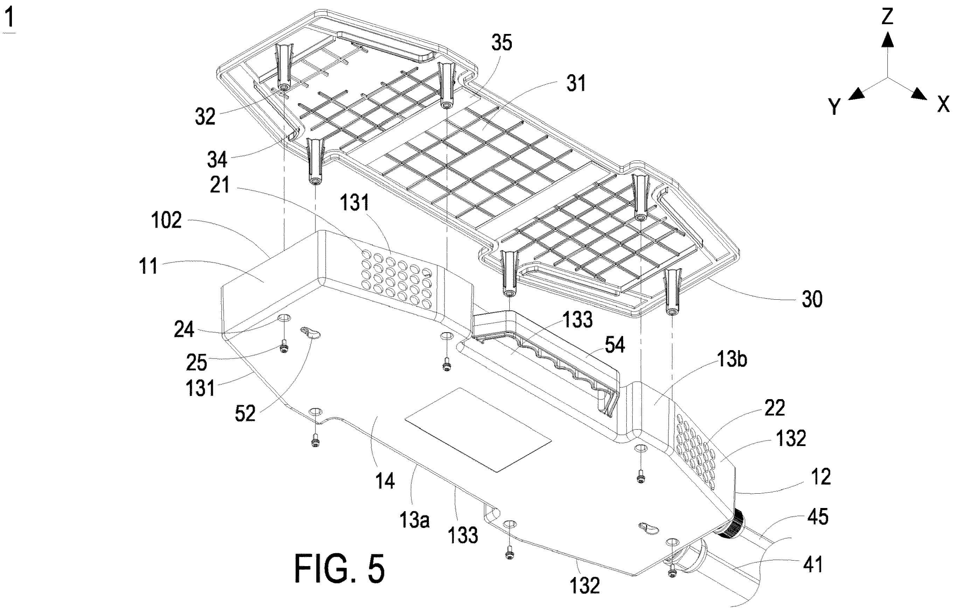

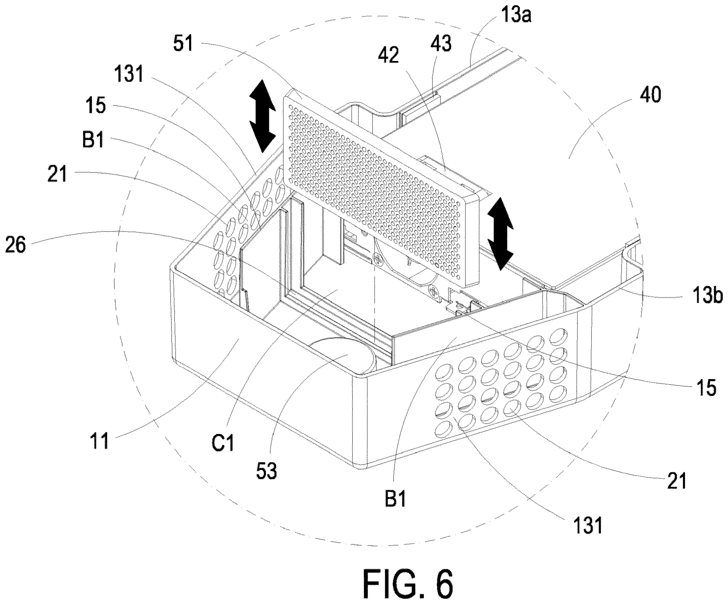

Please refer to FIGS. 1 to 8. In the embodiment, a power-supply-unit assembly structure 1 is provided and includes a housing base 10, a cover 30 and a power supply unit (PUS). In the embodiment, the housing base 10 includes a first ending wall 11, a second ending wall 12, two lateral walls 13 and a bottom plate 14. The first ending wall 11 and the second ending wall 12 are disposed opposite to each other. The two lateral walls 13 are connected between the first ending wall 11 and the second ending wall 12, respectively. That is, the two opposite ends of the first ending wall 11 are connected to the front end of the lateral wall 13a and the front end of the lateral wall 13b, respectively, and the two opposite ends of the second ending wall 12 are connected to the rear end of the lateral wall 13a and the rear end of the lateral wall 13b, respectively. Preferably but not exclusively, the lateral wall 13a and the lateral wall 13b are arranged symmetrically to each other. The present disclosure is not limited thereto. In the embodiment, the first ending wall 11, the second ending wall 12 and the two lateral walls 13 are disposed around the outer edge of the bottom plate 14 to form an accommodation space 101. In the embodiment, the housing base 10 further includes two ventilation inlets 21, two ventilation outlets 22, two first retaining walls 15, two second retaining walls 16 and a wire-in through hole 23. Two of the ventilation inlets 21 are arranged in pairs. One ventilation inlet 21 runs through the lateral wall 13a and disposed adjacent to the first ending wall 11, and another ventilation inlet 21 runs through the lateral wall 13b and is disposed adjacent to the first ending wall 11. Moreover, in the embodiment, two of the ventilation outlet 22 are arranged in pairs. One ventilation outlet 22 runs through the lateral wall 13a and is disposed adjacent to the second ending wall 12, and another ventilation outlet 22 runs through the lateral wall 13b and is disposed adjacent to the second ending wall 12. Preferably but not exclusively, in the embodiment, two of the first retaining walls 15 are arranged in pairs. The two first retaining walls 15 are spatially corresponding to the two ventilation inlets 21 and arranged between the corresponding ventilation inlets 21 and the accommodation space 101, respectively. Preferably but not exclusively, in the embodiment, two of the second retaining walls 16 are arranged in pairs. The two second retaining wall 16 are spatially corresponding to the two ventilation outlets 22 and arranged between the corresponding ventilation outlet 22 and the accommodation space 101, respectively. Preferably but not exclusively, the ventilation inlets 21 and the ventilation outlets 22 are in a multi-hole structure. The two ventilation inlets 21 are in communication with the two ventilation outlets 22 through the accommodation space 101. The wire-inlet through hole 23 is disposed on the second ending wall 12. In the embodiment, the cover 30 is spatially corresponding to the housing base 10. Preferably but not exclusively, the cover 30 is detachably connected to the first ending wall 11, the second ending wall 12, the two lateral walls 13, the first retaining walls 15 and the second retaining walls 16 of the housing base 10. In the embodiment, the power supply unit includes a main body 40, a power cord 41 and a charging cord 45. The main body 40 is accommodated in the accommodation space 101 and includes a fan 42. The fan 42 is configured to drive an airflow, which is inhaled through the ventilation inlets 21, transported along the first retaining walls 15 into the accommodation space 101, flowing through the main body 40 of the power supply unit in the accommodation space 101, then transported along the second retaining walls 16 and discharged through the ventilation outlets 22. The power cord 41 and the charging cord 45 pass through the wire-in through hole 23 on the second ending wall 12 and is connected to the main body 40. Preferably but not exclusively, in the embodiment, the main body 40 includes a charging device, and the power cord 41 is a power input cord connected to the mains electricity the power source, so that the mains electricity and the power source is connected to the main body 40. Preferably but not exclusively, in the embodiment, the charging cord 45 is a power output cord, which outputs the converted power from the main body 40. Preferably but not exclusively, the main body 40 is a charging device having one or more power conversion functions of AC/AC, AC/DC, DC/DC, and DC/AC. In other embodiments, the power cord 41 and the charging cord 45 are integrated into one piece. The present disclosure is not limited thereto.

In the embodiment, the housing base 10 includes a first fastened hole 24. The cover 30 includes a second fastened hole 32. Moreover, the first fastened hole 24 and the second fastened hole 32 are engaged with each other through a fastening element 25, such as a screw, so as to achieve the combination of the housing base 10 and the cover 30. In the embodiment, when the housing base 10 and the cover 30 are detachably assembled through the engagement of the fastening element 25, the first fastened hole 24 and the second fastened hole 32, a top edge 102 collaboratively formed by the first ending wall 11, the second ending wall 12, the lateral wall 13a, the lateral wall 13b, the first retaining walls 15 and the second retaining walls 16 further abuts against a joint surface 31 of the cover 30, so that the housing base 10 and the cover 30 are closely connected to each other.

In the embodiment, the cover 30 includes a sealing rubber ring 34 and an accommodation groove 33. The accommodation groove 33 is disposed on the joint surface 31. Preferably but not exclusively, by using the injection molding, the sealing rubber ring 34 is embedded in the joint surface 31 of the cover through the accommodation groove 33 on the joint surface 31. In the embodiment, the first ending wall 11, the second ending wall 12, the lateral wall 13a, the lateral wall 13b, the two first retaining walls 15 and the two second retaining walls 16 of the housing base 10 collaboratively form the top edge 102. Preferably but not exclusively, the shape of the sealing rubber ring 34 is similar to that of the top edge 102. In other words, the sealing rubber ring 34 is spatially corresponding to the top edge 102 collaboratively formed by the first ending wall 11, the second ending wall 12, the lateral wall 13a, the lateral wall 13b, the first retaining walls 15 and the second retaining walls 16. When the housing base 10 and the cover 30 are assembled together through the fastening element 25, the top edge 102 collaboratively formed by the first ending wall 11, the second ending wall 12, the lateral wall 13a, the lateral wall 13b, the first retaining walls 15 and the second retaining walls 16 abuts against the sealing rubber ring 34 on the cover 30, so that the housing base 10 and cover 30 are fastened to each other closely and the sealing effect is achieved. On the other hand, the sealing rubber ring 34 is formed on the cover 30 by injection molding, and the function of a waterproof rubber ring is provided. It is conducive to the repeated disassembly and replacement of the power supply unit accommodated in the accommodation room 101. It also facilitates to prevent the sealing rubber ring 34 from displacement failure after the user detaches the cover 30 from the housing base 10.

In the embodiment, each one of the lateral wall 13a and the lateral wall 13b arranged in pairs includes a first adjoining section 131. Two of the first adjoining sections 131 are connected to opposite ends of the first ending wall 11, respectively. In the embodiment, the two first adjoining sections 131, like two lateral legs of an isosceles trapezoid, have a spaced distance reduced gradually in a first direction (i.e., the inverse X axial direction) approaching toward the first ending wall 11. In the embodiment, two of the ventilation inlets 21 are arranged in pairs on the two first adjoining sections 131 and passing through the two first adjoining sections 131, respectively.

In an embodiment, two of the first retaining walls 15 are also arranged in pairs. Each one of the first retaining walls 15 has a rear end connected to one end of the corresponding first adjoining sections 131 away from the first ending wall 11, and a front end of the first retaining wall 15 is spaced apart from the first ending wall 11. In that, a first buffer chamber B1 is formed between each one of the first adjoining sections 131 and the corresponding one of the first retaining walls 15. In addition, the two first retaining walls 15, like two lateral legs of an isosceles trapezoid, have a spaced distance reduced gradually in the first direction (i.e., the inverse X axial direction) approaching toward the first ending wall 11. In that, a first communication chamber C1 is formed between the two first retaining walls 15.

In the embodiment, each one of the lateral wall 13a and the lateral wall 13b arranged in pairs includes a second adjoining section 132. Two of the second adjoining sections 132 are connected to opposite ends of the second ending wall 11, respectively. In the embodiment, the two second adjoining sections 132, like two lateral legs of an isosceles trapezoid, have a spaced distance reduced gradually in a second direction (i.e., the X axial direction) approaching toward the second ending wall 12. In the embodiment, two of the ventilation outlets 22 are arranged in pairs on the two second adjoining sections 132 and passing through the two second adjoining sections 132, respectively.

Furthermore, in an embodiment, two of the second retaining walls 16 are also arranged in pairs. Each one of the second retaining walls 16 has a rear end connected to one end of the corresponding second adjoining sections 132 away from the second ending wall 12, and a front end of the second retaining wall 16 is spaced apart from the second ending wall 12. In that, a second buffer chamber B2 is formed between each one of the second adjoining sections 132 and the corresponding one of the second retaining walls 16. In addition, the two second retaining walls 16, like two lateral legs of an isosceles trapezoid, have a spaced distance reduced gradually in the second direction (i.e., the X axial direction) approaching toward the second ending wall 11. In that, a second communication chamber C2 is formed between the two second retaining walls 16.

In the embodiment, the power-supply-unit assembly structure 1 further includes a dustproof filter screen 51 arranged between the two first retaining walls 15, and located between the first ending wall 11 and the main body 40 of the power supply unit 40, so that the air for flowing through the main body is filtered thereby. In the embodiment, the housing base 10 further includes a filter-screen sliding slot 26 arranged among the bottom plate 14 and the two first retaining walls 15, and it facilitates the dustproof filter screen 51 to be detachably accommodated in the filter-screen sliding slot 26. Moreover, when the housing base 10 and the cover 30 are connected closely, the dustproof filter screen 51 is fixed among the joint surface 31 of the cover 30 and the bottom plate 14 and the two first retaining walls 15 of the housing base 10. On the other hand, since the fastened combination of the housing base 10 and the cover 30 is implemented through the sealing rubber ring 34, it is also conducive to the repeated disassembly and replacement of the dustproof filter screen 51. The user can replace the filter screens at different dust-proof grades according to the use requirements, so as to optimize the dust-proof effects of the power supply unit.

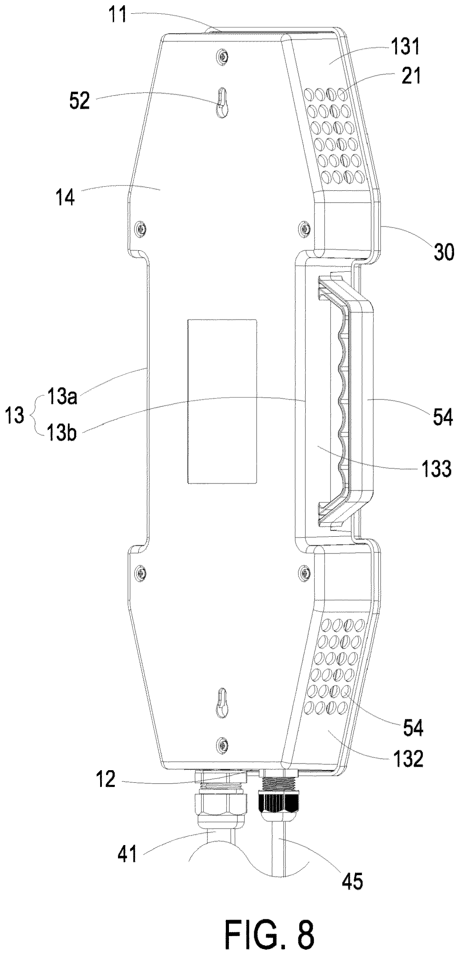

In the embodiment, the housing base 10 further includes at least one hanging hole 52 embedded from an outer side of the bottom plate 14 and disposed adjacent to the first ending wall 11 or/and the second ending wall 12 for the user to hang the power-supply-unit assembly structure 1 vertically in use, as shown in FIG. 8. In the embodiment, the hanging hole 52 further runs through the bottom plate 14. Preferably but not exclusively, the housing base 10 further includes a cap 53 for covering the hanging hole 52 from an inner side of the bottom plate 14 to the outer side, so that the hanging hole 52 and the accommodation space 101 isolated. With the special waterproof and dustproof cap 53 covering the hanging hole 52 for sealing and protection, the airflow driven by the fan 42 of the power supply unit is not affected.

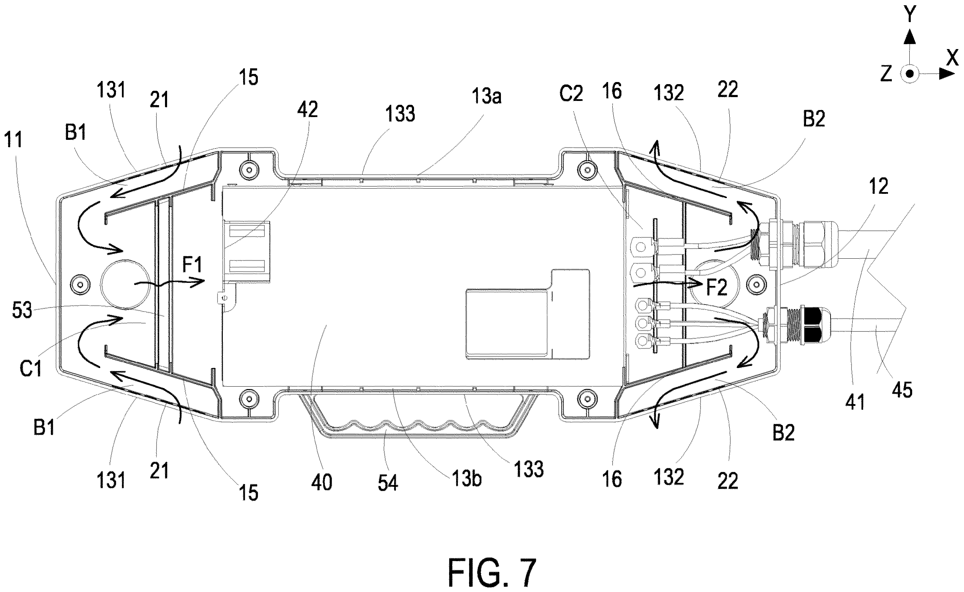

In the embodiment, the ventilation inlets 21 are sequentially in communication with the first buffer chambers B1, the first communication chamber C1, the accommodation space 101, the second communication chamber C2, the second buffer chambers B2, so as to be in communication with the ventilation outlets 22. As shown in FIG. 7, when the fan 42 of the power supply unit is enabled to drive the airflow F 1, F2, the airflow F 1 is inhaled into the two first buffer chambers B1 through the two ventilation inlets 21, respectively, converged into and transported through the first communication chamber C1, and then introduced toward the main body 40 of the power supply unit accommodated in the accommodation space 101, so as to cool the internal electronic components of the main body 40. After completing the heat exchange of heat dissipation, the airflow F2 is transported into the second communication chamber C2 from the main body 40 of the power supply unit accommodated in the accommodation space 101, divided to flow through the two second buffer chambers B2, and finally discharged out of the second buffer chambers B2 through the ventilation outlets 22. In this way, the airflow path formed by the combination of the housing base 10 and the cover 30 is designed in a circuitous path. The first retaining wall 15 and the second retaining wall 16 are severed as the protection walls for the ventilation inlet 21 and the ventilation outlet 22, respectively. In addition, the first buffer chambers B1 formed by the first adjoining sections 131 of the outer lateral walls 13a, 13b and the inner-corresponding ones of the first retaining walls 15, and the second buffer chambers B2 formed by the second adjoining sections 132 of the outer lateral walls 13a, 13b and the inner-corresponding ones of the second inner retaining wall 16, are further served as the waterproof structure, to avoid the water intrusion. When the power-supply-unit assembly structure 1 is hung outdoors or on a wall (not shown) through the hanging hole 52 for use, the water entering the first buffer chambers B1 through the ventilation inlets 21 is blocked by the first retaining walls 15 and cannot enter the first communication chamber C1. The water accumulated in the first buffer chambers B1 is further discharged out of the first buffer chambers B1 through the ventilation inlets 21. In other words, 16 when the housing base 10 and the cover 30 are connected closely, the circuitous structures are formed between the outer lateral walls 13a, 13b and the inner-corresponding ones of the first retaining walls 15 and the second retaining walls, so as to avoid the intrusion of water. Thereby, the dry air inhaled through the ventilation inlets 21 is transported in the circuitous path and filtered through the dustproof filter screen 51, flows into the power supply unit for cooling cool the inner electronic components in the main body 40 of the power supply unit. Finally, the air after heat exchange of heat dissipation is discharged out through the ventilation outlets 22. Certainly, the use of the power-supply-unit assembly structure 1 is not limited thereto.

In the embodiment, each of the lateral wall 13a and the lateral wall 13b arranged in pairs includes a recessed section 133 in addition to the first adjoining section 131 and the second adjoining section 132. Two of the recessed sections 133 are connected between the two first adjoining sections 131 and the two second adjoining sections 132, respectively, and arranged in parallel to each other. In the embodiment, the housing base 10 further includes a handle 54 disposed on an outside of the recessed section 133 of the lateral wall 13b. Preferably but not exclusively, in other embodiments, the handle 54 is disposed on the recessed section 133 of the lateral wall 13a or other region of the housing base 10 for being held by the user. On the other hand, in the embodiment, the power-supply-unit assembly structure 1 further includes a buffer spacer 43 disposed between the main body 40 of the power supply unit and the two lateral walls 13a, 13b of the housing base 10. The power-supply-unit assembly structure 1 further includes a buffer spacer 43 disposed between the main body 40 of the power supply unit and the bottom plate 14 of the housing base 10, and a buffer spacer 35 disposed between the main body 40 of the power supply unit and the joint surface 31 of the cover 30, so as to enhance the protection level of the power supply unit. Certainly, the present disclosure is not limited thereto.

Notably, in the embodiment, the ventilation inlets 21, the ventilation outlets 22, the first retaining walls 15 and the second retaining walls 16 are all described as a pair. In other embodiments, one set of the corresponding two sets of the ventilation inlets 21, the ventilation outlets 22, the first retaining wall 15 and the second retaining wall 16 is omitted, and the present disclosure is not limited thereto. In addition, the connection between the housing base 10 and the cover 30 through the sealing rubber ring 34, the disassembly and replacement of the dustproof filter screen 51, the arrangement of the hanging hole 52 and the arrangement of the buffer spacers 43, 44, and 35 are adjustable according the practical requirements. The present disclosure is not limited thereto, and not redundantly described hereafter.

In summary, the present disclosure provides a power-supply-unit assembly structure to improve the protection level of the power supply unit for dustproof, waterproof and impact resistance, and be capable of ensuring the heat dissipation performance. Under improving the protection level of the power supply unit for dustproof, waterproof and impact resistance and enhancing heat dissipation performance, it facilitates to install or achieve the portability at the same time. With the main body of the power supply unit fixed through the combination of the housing base and the cover, it facilitates to improve the protection strength of the original power supply unit and make the entire assembly structure to meet the characteristic requirements of portable supply devices. Preferably, the airflow path formed by the combination of the housing base and the cover body is designed in a circuitous path. The ventilation inlet and the ventilation outlet are equipped with the protective retaining wall structures correspondingly, so that a waterproof structure is formed between the outer lateral wall and the inner retaining wall. In addition, the housing base includes a built-in replaceable dust-proof filter screen to achieve a comprehensive improvement of the protection level. In that, the power-supply-unit assembly structure is suitable for semi-outdoor and outdoor environments. The accommodation space is formed by the combination of the housing base and the cover, it allows to change the capacity of the built-in power supply unit according to different power demands. On the other hand, the housing base and the cover are connected to each other closely through the sealing rubber ring. Preferably, the sealing rubber ring is a waterproof rubber ring embedded on the abutting surface of the cover by means of injection molding. It is conducive to repeated disassembly and replacement of the filter screen disposed on the housing base. Furthermore, it facilitates to prevent the sealing rubber ring from displacement failure after the user detaches the cover. When the housing base and the cover are assembled with each other and connected closely, the sealing protection between the housing base and the cover is achieved through the sealing rubber ring. It allows to replace the filter screens at different dust-proof grades according to the use requirements, so as to optimize the dust-proof effects of the power supply unit. Furthermore, the power-supply-unit assembly structure includes a hanging hole for hanging it on a wall. Preferably, the hanging hole is equipped with a special waterproof-dustproof cap for achieving sealing and protection, and the airflow driven by the fan of the power supply unit is not affected. In other words, when the housing base and the cover are assembled with each other and connected closely, the circuitous structures are formed between the outer lateral wall and the inner retaining wall to avoid the water intrusion. In that, the dry air inhaled from the ventilation inlet is transported in a circuitous path and filtered through the filter, flows into the power supply unit for cooling cool the inner electronic components. Finally, the heat-exchanged air is discharged out of the ventilation outlet. In this way, a smooth airflow is maintained in the power-supply-unit assembly structure of the present disclosure. Moreover, the heat dissipation performance is enhanced, a water-repellent structure is provided, and the protection and the portability are improved at the same time.

## Claims

1. A power-supply-unit assembly structure (1) **characterized by** comprising:
a housing base (10) comprising a first ending wall (11), a second ending wall (12), two lateral walls (13) and a bottom plate (14), wherein the first ending wall (11) and the second ending wall (12) opposite to each other, and the two lateral walls (13) connected between the first ending wall (11) and the second ending wall (12), respectively, are disposed around the bottom plate (14) to form an accommodation space (101), and the housing base (10) further comprises a ventilation inlet (21), a ventilation outlet (22), a first retaining wall (15), a second retaining wall (16) and a wire-in through hole (23), wherein the ventilation inlet (21) runs through the lateral wall (13) and is disposed adjacent to the first ending wall (11), the ventilation outlet (22) runs through the lateral wall (13) and is disposed adjacent to the second ending wall (12), the first retaining wall (15) is spatially corresponding to the ventilation inlet (21) and arranged between the ventilation inlet (21) and the accommodation space (101), the second retaining wall (16) is spatially corresponding to the ventilation outlet (22) and arranged between the ventilation outlet (22) and the accommodation space (101), the ventilation inlet (21) is in communication with the ventilation outlet (22) through the accommodation space (101), and the wire-inlet through hole (23) is disposed on the second ending wall (12);
a cover (30) spatially corresponding to the housing base (10) and detachably connected to the first ending wall (11), the second ending wall (12), the two lateral walls (13), the first retaining wall (15) and the second retaining wall (16) of the housing base (10); and
a power supply unit comprising a main body (40) and a power cord (41), wherein the main body (40) is accommodated in the accommodation space (101) and comprises a fan (42), the fan (42) is configured to drive an airflow (F 1, F2), which is inhaled through the ventilation inlet (21), transported along the first retaining wall (15) into the accommodation space (101), flowing through the main body (40) of the power supply unit in the accommodation space (101), then transported along the second retaining wall (16) and discharged through the ventilation outlet (22), and the power cord (41) passes through the wire-in through hole (23) on the second ending wall (12) and is connected to the main body (40).

2. The power-supply-unit assembly structure (1) according to claim 1, wherein the housing base (10) comprises a first fastened hole (24), the cover (30) comprises a second fastened hole (32), and the first fastened hole (24) and the second fastened hole (32) are engaged with each other through a fastening element, wherein a top edge (102) collaboratively formed by the first ending wall (11), the second ending wall (12), the two lateral walls (13), the first retaining wall (15) and the second retaining wall (16) abuts against a joint surface (31) of the cover (30), and the housing base (10) and the cover (30) are closely connected to each other, wherein the cover (30) comprises a sealing rubber ring (34) embedded in the joint surface (31) of the cover (30) through an accommodation groove (33) on the joint surface (31), and spatially corresponding to the top edge (102) collaboratively formed by the first ending wall (11), the second ending wall (12), the two lateral walls (13), the first retaining wall (15) and the second retaining wall (16).

3. The power-supply-unit assembly structure (1) according to claim 1, wherein the two lateral walls (13) are arranged in pairs and comprises two first adjoining sections (131) connected to two opposite ends of the first ending wall (11), respectively, and the two first adjoining sections (131) have a spaced distance reduced gradually in a first direction approaching toward the first ending wall (11), wherein two of the ventilation inlets (21) are arranged in pairs on the two first adjoining sections (131) and passing through the two first adjoining sections (131), respectively, wherein two of the first retaining walls (15) are arranged in pairs and connected to ends of the two first adjoining sections (131) away from the first ending wall (11), wherein the two first retaining walls (15) have a spaced distance reduced gradually in the first direction approaching toward the first ending wall (11), wherein a first buffer chamber (B1) is formed between each one of the first adjoining sections (131) and a corresponding one of the two first retaining walls (15), a first communication chamber (C1) is formed between the two first retaining walls (15), and the airflow (F1) is inhaled into the first buffer chamber (B1) through the ventilation inlet (21), transported through the first communication chamber (C1), and then introduced toward the main body (40) of the power supply unit in the accommodation space (101).

4. The power-supply-unit assembly structure (1) according to claim 1, wherein the two lateral walls (13) are arranged in pairs and comprises two first adjoining sections (131) connected to two opposite ends of the first ending wall (11), respectively, and the two first adjoining sections (131) have a spaced distance reduced gradually in a first direction approaching toward the first ending wall (11), wherein two of the ventilation inlets (21) are arranged in pairs on the two first adjoining sections (131) and passing through the two first adjoining sections (131), respectively, wherein two of the first retaining walls (15) are arranged in pairs and connected to ends of the two first adjoining sections (131) away from the first ending wall (11), wherein the two first retaining walls (15) have a spaced distance reduced gradually in the first direction approaching toward the first ending wall (11), wherein the power-supply-unit assembly structure (1) further comprises a dustproof filter screen (51) arranged between the two first retaining walls (15), and located between the first ending wall (11) and the main body (40) of the power supply unit (40).

5. The power-supply-unit assembly structure (1) according to claim 4, wherein the housing base (10) further comprises a filter-screen sliding slot (26) arranged among the bottom plate (14) and the two first retaining walls (15), and the dustproof filter screen (51) is detachably accommodated in the filter-screen sliding slot (26), and fixed among the joint surface (31) of the cover (30) and the bottom plate (14) and the two first retaining walls (15).

6. The power-supply-unit assembly structure (1) according to claim 1, wherein the two lateral walls (13) are arranged in pairs and comprises two second adjoining sections (132) connected to two opposite ends of the second ending wall (12), respectively, and the two first adjoining sections (132) have a spaced distance reduced gradually in a second direction approaching toward the second ending wall (12), wherein two of the ventilation outlets (22) are arranged in pairs on the two second adjoining sections (132) and passing through the two second adjoining sections (132), respectively, wherein two of the second retaining walls (16) are arranged in pairs and connected to ends of the two second adjoining sections (132) away from the second ending wall (12), wherein the two second retaining walls (16) have a spaced distance reduced gradually in the second direction approaching toward the second ending wall (12), wherein a second buffer chamber (B2) is formed between each one of the second adjoining sections (132) and a corresponding one of the two second retaining walls (16), a second communication chamber (C2) is formed between the two second retaining walls (16), and the airflow (F2) is transported into the second communication chamber (C2) from the main body (40) of the power supply unit in the accommodation space (101), and then discharged out of the ventilation outlet (22) through the second buffer chamber (B2).

7. The power-supply-unit assembly structure (1) according to claim 1, wherein the housing base (10) further comprises at least one hanging hole (52) embedded from an outer side of the bottom plate (14) and disposed adjacent to the first ending wall (11) or/and the second ending wall (12).

8. The power-supply-unit assembly structure (1) according to claim 7, wherein the hanging hole (52) runs through the bottom plate (14), and the housing base (10) further comprises a cap (53) covering the hanging hole (52) from an inner side of the bottom plate (14) to the outer side, so that the hanging hole (52) and the accommodation space (101) isolated.

9. The power-supply-unit assembly structure (1) according to claim 1, wherein the housing base (10) further comprises a handle (54) disposed on an outside of one of the two lateral walls (13b).

10. The power-supply-unit assembly structure (1) according to claim 1, wherein the two lateral walls (13) are arranged in pairs and comprises two first adjoining sections (131), two second adjoining sections (132) and two recessed sections (133), the two first adjoining sections (131) are connected to two opposite ends of the first ending wall (11), respectively, and have a spaced distance reduced gradually in a first direction approaching toward the first ending wall (11), the two second adjoining sections (132) are connected to two opposite ends of the second ending wall (12), respectively, and have a spaced distance reduced gradually in a second direction approaching toward the second wall (12), and the two recessed sections (133) are connected between the two first adjoining sections (131) and the two second adjoining sections (132) and arranged in parallel to each other.

11. The power-supply-unit assembly structure (1) according to claim 10, wherein the housing base (10) further comprises a handle (54) disposed on an outside of one of the two recessed sections (133).

12. The power-supply-unit assembly structure (1) according to claim 1, further comprising a buffer spacer (43) disposed between the main body (40) of the power supply unit and the two lateral walls (13) of the housing base (10).

13. The power-supply-unit assembly structure (1) according to claim 1, further comprising a buffer spacer (44) disposed between the main body (40) of the power supply unit and the bottom plate (14) of the housing base (10), or between the main body (40) of the power supply unit and the joint surface (31) of the cover (30).

14. The power-supply-unit assembly structure (1) according to claim 1, wherein the ventilation inlet (21) and the ventilation outlet (22) are in a multi-hole structure.

15. The power-supply-unit assembly structure (1) according to claim 1, wherein the main body (40) comprises a charger, and the power supply unit further comprises a charging cord (45) passing through the wire-in through hole (23) on the second ending wall (12) and connected to the main body (40).
